# EUROPÄISCHE PATENTSCHRIFT

(11) **EP 0 921 213 B1**
(45) Veröffentlichungstag und Bekanntmachung des Hinweises auf die Patenterteilung: **09.05.2001**
(21) Anmeldenummer: 98121576.7
(22) Anmeldetag: 19.11.1998
(51) Int. Cl.: C30B 15/14, C30B 15/00, C30B 15/02

(54) **Verfahren und Heizvorrichtung zum Aufschmelzen von Halbleitermaterial**
Process and apparatus for melting semiconductor material
Procédé et appareillage pour faire fondre un produit semiconducteur

(30) Priorität: 02.12.1997 DE 19753477
(43) Veröffentlichungstag der Anmeldung: 09.06.1999
(73) Patentinhaber: Wacker Siltronic Gesellschaft für Halbleitermaterialien Aktiengesellschaft, 84489 Burghausen (DE)
(72) Erfinder: von Ammon, Wilfried, Dr., 5122 Hochburg/Ach (AT); Tomzig, Erich, Dr., 84508 Burgkirchen (DE); Fuchs, Paul, 5231 Schalchen (AT)
(74) Vertreter: Rimböck, Karl-Heinz, Dr.

(56) Entgegenhaltungen:
- US-A- 5 443 034
- PATENT ABSTRACTS OF JAPAN vol. 015, no. 456 (C-0886), 20. November 1991 & JP 03 193694 A (SUMITOMO METAL IND LTD), 23. August 1991
- PATENT ABSTRACTS OF JAPAN vol. 098, no. 002, 30. Januar 1998 & JP 09 263481 A (SUMITOMO SITIX CORP), 7. Oktober 1997
- PATENT ABSTRACTS OF JAPAN vol. 098, no. 001, 30. Januar 1998 & JP 09 235175 A (SUMITOMO SITIX CORP), 9. September 1997
- PATENT ABSTRACTS OF JAPAN vol. 098, no. 001, 30. Januar 1998 & JP 09 227276 A (SUMITOMO SITIX CORP), 2. September 1997
- PATENT ABSTRACTS OF JAPAN vol. 016, no. 470 (C-0990), 30. September 1992 & JP 04 170388 A (NEC CORP), 18. Juni 1992

## Beschreibung

Gegenstand der Erfindung ist ein Verfahren zum Aufschmelzen von Halbleitermaterial in einem Tiegel, der sich in einem Rezipienten befindet. Gegenstand der Erfindung ist weiterhin eine Heizvorrichtung, die sich zur Durchführung des Verfahrens eignet.

Das Verfahren wird vorzugsweise zur Herstellung von Einkristallen nach der Czochralski-Methode angewendet. Damit ein Einkristall nach dieser Methode aus einer Schmelze gezogen werden kann, muß zunächst das Halbleitermaterial, das üblicherweise in einem Quarztiegel eingefüllt ist, aufgeschmolzen werden. Die dafür benötigte Energie wird üblicherweise von einer feststehenden Heizvorrichtung aufgebracht, die um den Tiegel herum angeordnet ist.

Der Tiegel wird während des Aufschmelzvorgangs thermisch erheblich belastet. Infolgedessen kommt es zu einer sogenannten Lochfraßkorrosion des Tiegelmaterials, wobei
Partikel entstehen, die später ein versetzungsfreies Wachsen des Einkristalls unmöglich machen können. Die Temperatur an der Tiegelwand sowie die Zeit des Aufschmelzens sollte daher so gering wie möglich gehalten werden.

In den Patent Abstracts of Japan vol. 098, no. 002 vom 30.01.1998 und der JP-09263481 A ist eine Vorrichtung zum Ziehen eines Einkristalls offenbart, die eine über dem Tiegel angeordnete Heizvorrichtung umfaßt.

Gegenstand der Erfindung ist auch eine Heizvorrichtung, die zur Durchführung des Verfahrens geeignet ist. Es wird eine Heizvorrichtung vorgeschlagen, die verfahrbar ist und einen Heizer umfaßt, der. von einer Schleusenkammer über dem Rezipienten durch ein geöffnetes Absperrventil in den Rezipienten in Richtung auf das Halbleitermaterial abgesenkt und in die Schleusenkammer zurückgehoben werden kann.

Die Erfindung ermöglicht ein rasches Aufschmelzen des Halbleitermaterials vom Zentrum der Halbleitermaterial-Charge aus, wobei das Tiegelmaterial geschont wird, da ein wesentlicher Teil der benötigten Energie nicht über die Tiegelwand eingebracht wird. Darüber hinaus greift das Verfahren in bestehende Abläufe der eigentlichen Kristallherstellung nicht ein, so daß bewährte Ziehbedingungen unverändert beibehalten werden können.

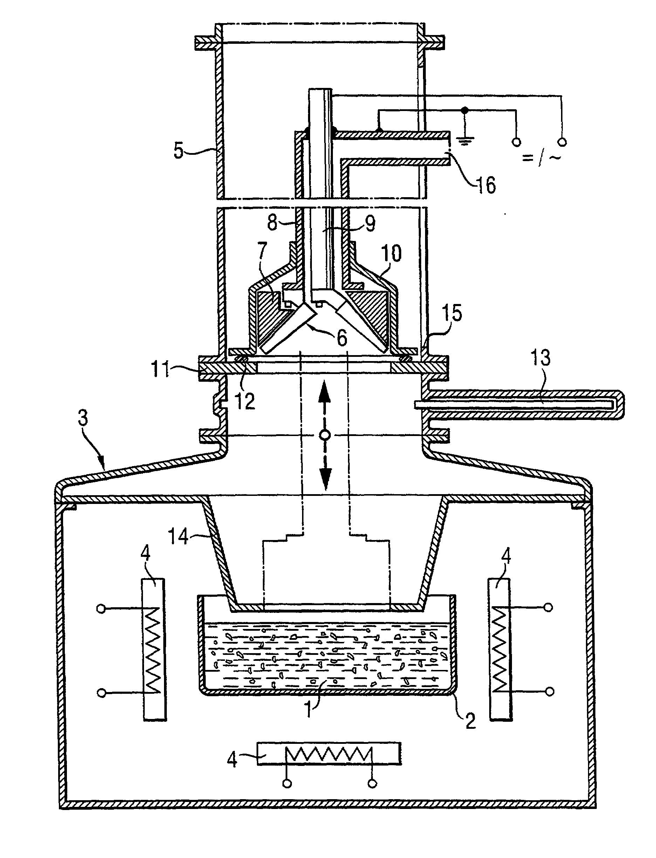

Die Erfindung wird nachfolgend anhand einer Figur näher erläutert. Die Figur zeigt schematisch in Schnittdarstellung die Seitenansicht einer Anlage zum Ziehen von Einkristallen nach der Czochralski-Methode. Es sind nur solche Merkmale gezeigt, die zur Erläuterung der Erfindung notwendig sind.

Der mit Halbleitermaterial 1 befüllte Tiegel 2 befindet sich in einem Rezipienten 3, der mit Inertgas gespült und evakuiert werden kann. Eine feststehende Heizvorrichtung 4'umgibt den Tiegel. Gegebenenfalls kann darüber hinaus eine zusätzliche feststehende Heizvorrichtung vorgesehen sein, die unter dem Tiegelboden angeordnet ist und als Bodenheizer bezeichnet wird. Über dem Tiegel ist eine Schleusenkammer 5 auf den Rezipienten geflanscht. Sie beherbergt eine verfahrbare Heizvorrichtung mit einem Heizer 6, dessen Vorderseite zum Halbleitermaterial 1 gerichtet ist und dessen Rückseite durch eine thermische Isolierung 7 isoliert ist. Der Heizer umfaßt gemäß der dargestellten Ausführungsform zwei Heizelemente, die an den Enden eines Rohres 8 und eines Schaftes 9 montiert sind. Der Heizer ist vorzugsweise als elektrische Widerstandsheizung oder Induktionsheizung ausgeführt und besteht beispielsweise aus Graphit. Der benötigte elektrische Strom (Gleichstrom oder Wechselstrom oder mit Wechselstromanteilen modulierter Gleichstrom) wird bevorzugt über das Rohr 8 und den Schaft 9 zugeführt. Das Rohr und der Schaft können gemeinsam axial angehoben und abgesenkt werden. Der zwischen dem Rohr und dem Schaft bestehende Zwischenraum dient zur Zuführung von Inertgas in den Rezipienten 3 oder zur Abführung von Abgas aus dem Rezipienten.. Die Heizvorrichtung umfaßt weiterhin eine evakuierbare und mit Inertgas spülbare Glocke 10, die über die thermische Isolierung 7 und den Heizer 6 gestülpt ist. Die Glocke ist auf einer Stützplatte 11 der Schleusenkammer 5 abgestützt. Vakuumfeste Dichtungen 12 zwischen der Glocke und der Stützplatte und zwischen der Glocke und dem Rohr 8 bilden eine gasdichte Sperre. Der Innenraum des Rezipienten kann mit Hilfe eines Absperrventils 13 gasdicht vom Innenraum der Schleusenkammer abgetrennt werden.

Zum Aufschmelzen des Halbleitermaterials wird die Glocke evakuiert und mit Inertgas gespült, und das Absperrventil 13 geöffnet. Das Rohr 8 und der Schaft 9 werden abgesenkt, bis der Heizer 6 eine Position möglichst nahe der Oberfläche des Halbleitermaterials erreicht hat. Der Abstand zwischen der Oberfläche des Heizers und der Oberfläche des Halbleitermaterials wird so groß gewählt, daß eine Berührung mit dem aufzuschmelzenden Halbleitermaterial ausgeschlossen werden kann. Der Heizer ist vorzugsweise derart ausgebildet, daß er in ein rohroder konusförmiges Hitzeschild 14 paßt, sofern dieses in den Rezipienten über dem Tiegel hängend eingebaut ist. Die Energie zum Aufschmelzen des Halbleitermaterials wird von der feststehenden Heizvorrichtung 4, einem gegebenenfalls vorhandenen Bodenheizer und dem abgesenkten Heizer 6 gemeinsam aufgebracht. Bevorzugt ist, die Energiebeiträge so zu verteilen, daß das Halbleitermaterial abhängig von seiner Lage im Tiegel aufschmilzt und Halbleitermaterial, das mit der Tiegelwand in Berührung steht, zuletzt aufschmilzt. Besonders bevorzugt ist, wenn sich die Front geschmolzenen Halbleitermaterials von der Mitte des Tiegels radial nach außen zur Tiegelwand bewegt, wenn man den Aufschmelzvorgang von einer Position über dem Tiegel betrachtet.

Nach dem Aufschmelzen des Halbleitermaterials wird der Heizer 6 zurück in die Schleusenkammer gehoben und das Absperrventil 13 geschlossen. Anschließend wird die Heizvorrichtung aus der Schleusenkammer durch eine Tür 15 entfernt. Das Ziehen eines Einkristalls wird daraufhin damit eingeleitet, daß ein Impfkristall mittels einer üblichen Ziehvorrichtung, die über der Schleusenkammer angeordnet ist (in der Figur nicht dargestellt) durch die gegebenenfalls evakuierte und mit Inertgas gespülte Schleusenkammer zur Oberfläche des gemolzenen Halbleitermaterials abgesenkt wird.

Als Alternative zur vorstehend beschriebenen Vorgehensweise kann die verfahrbare Heizvorrichtung mit der Schleusenkammer vom Rezipienten getrennt und beispielsweise auf einen anderen Rezipienten umgesetzt werden. An die Stelle der entfernten Schleusenkammer wird eine Ziehvorrichtung gesetzt.

## Patentansprüche

1. Verfahren zum Aufschmelzen von Halbleitermaterial in einem Tiegel, wobei sich der Tiegel in einem Rezipienten befindet und von einer feststehenden Heizvorrichtung umgeben ist, und ein Heizer einer verfahrbaren Heizvorrichtung aus einer Schleusenkammer über dem Rezipienten in den Rezipienten in Richtung auf das Halbleitermaterial abgesenkt wird, und das Halbleitermaterial mit Hilfe der feststehenden Heizvorrichtung und des abgesenkten Heizers geschmolzen wird, und der Heizer nach dem Aufschmelzen des Halbleitermaterials aus dem Rezipienten in die Schleusenkammer zurückgehoben wird, dadurch gekennzeichnet, daß der Heizer durch ein geöffnetes Absperrventil abgesenkt wird und sich eine Front geschmolzenen Halbleitermaterials, von einer Position über dem Tiegel aus betrachtet, von der Mitte des Tiegels radial nach außen bewegt.

2. Verfahren nach Anspruch 1, dadurch gekennzeichnet, daß die verfahrbare Heizvorrichtung nach dem Aufschmelzen des Halbleitermaterials durch eine Tür der Schleusenkammer entfernt wird.

3. Verfahren nach Anspruch 1 oder Anspruch 2, dadurch gekennzeichnet, daß Halbleitermaterial, das mit dem Tiegel in Berührung steht, zuletzt aufgeschmolzen wird.

4. Vorrichtung zum Aufschmelzen von Halbleitermaterial in einem Tiegel, wobei sich der Tiegel in einem Rezipienten befindet und eine Heizvorrichtung Energie aus einer Position über dem Tiegel auf das Halbleitermaterial abgibt, und die Heizvorrichtung verfahrbar ist und einen Heizer mit einer Vorderseite und einer Rückseite umfaßt, der von einer Schleusenkammer über dem Rezipienten in den Rezipienten in Richtung auf das Halbleitermaterial abgesenkt und in die Schleusenkammer zurückgehoben werden kann, gekennzeichnet durch ein Absperrventil zwischen der Schleusenkammer und dem Rezipienten, und durch eine thermische Isolierung, die die Rückseite des Heizers isoliert, wodurch die Heizwirkung des Heizers nur von der zum Halbleitermaterial gerichteten Vorderseite des Heizers ausgeht und das Tiegelmaterial geschont wird.

5. Vorrichtung nach Anspruch 4, dadurch gekennzeichnet, daß die Heizvorrichtung durch eine Tür der Schleusenkammer entfernt werden kann.

6. Vorrichtung nach Anspruch 4, gekennzeichnet durch ein Hitzeschild, das den Heizer umgibt, wenn er in Richtung auf das Halbleiterrnaterial abgesenkt worden ist.

## Claims

1. Process for melting semiconductor material in a crucible, the crucible being located in a container and being enclosed by a fixed heating device, and a heater of a displaceable heating device being lowered from a lock chamber above the container into the container in the direction of the semiconductor material, and the semiconductor material being melted using the fixed heating device and the lowered heater, and the heater being raised back out of the container into the lock chamber after the semiconductor material has been melted characterized in that the heater is lowered through an open shut-off valve and a front of melted semiconductor material moves from the centre of the crucible radially outwards, as observed from a position above the crucible.

2. Process according to Claim 1, characterized in that the displaceable heating device is removed through a door in the lock chamber after the semiconductor material has been melted.

3. Process according to Claim 1 or Claim 2, characterized in that semiconductor material which is in contact with the crucible is melted last.

4. Device for melting semiconductor material in a crucible, the crucible being located in a container, and a heating device transmitting energy to the semiconductor material from a position above the crucible, and the heating device being displaceable and comprising a heater with a front side and a rear side which can be lowered from a lock chamber above the container into the container in the direction of the semiconductor material, and raised back into the lock chamber characterized by a shut-off valve between the lock chamber and the container, and by a thermal insulation, which insulates the rear side of the heater, whereby the heating effect of the heater emanates only from the front side of the heater, directed towards the semiconductor material, and the crucible material is spared.

5. Device according to Claim 4, characterized in that the heating device can be removed through a door in the lock chamber.

6. Device according to Claim 4, characterized by a heat shield, which surrounds the heater when it has been lowered in the direction of the semiconductor material.

## Revendications

1. Procédé pour faire fondre un matériau semi-conducteur dans un creuset, dans lequel le creuset se trouve dans un récipient et est entouré par un dispositif de chauffage fixe, et un élément chauffant d'un dispositif de chauffage déplaçable est abaissé depuis une chambre d'écluse par-dessus le récipient dans le récipient, dans la direction du matériau semi-conducteur, et le matériau semi-conducteur est fondu à l'aide du dipositif de chauffage fixe et de l'élément chauffant abaissé, et 1' élément chauffant est relevé à partir du récipient dans la chambre d'écluse après la fusion du matériau semi-conducteur caractérisé en ce que l'élément chauffant est abaissé par une soupape d'arrêt ouverte et un front de matériau semi-conducteur fondu se déplace d'une position vue au-dessus du creuset, depuis le milieu du creuset radialement vers l'extérieur.

2. Procédé selon la revendication 1, caractérisé en ce que le dispositif de chauffage déplaçable est éloigné après la fusion du matériau semi-conducteur, par une porte dans la chambre d'écluse.

3. Procédé selon la revendication 1 ou la revendication 2, caractérisé en ce que du matériau semi-conducteur, qui se trouve en contact avec le creuset, est finalement fondu.

4. Dispositif pour faire fondre un matériau semi-conducteur dans un creuset, dans lequel le creuset se trouve dans un récipient et un dispositif de chauffage transmet de l'énergie à partir d'une position au-dessus du creuset au matériau semi-conducteur, et le dispositif de chauffage est déplaçable et comprend un élément de chauffage avec une face avant et une face arrière, qui peut être abaissé depuis une chambre d'écluse au-dessus du récipient dans le récipient dans la direction du matériau semi-conducteur et peut être relevé dans la chambre d'écluse, caractérisé par une soupape d'arrêt entre la chambre d'écluse et le récipient et par une isolation thermique qui isole la face arrière de l'élément chauffant, l'effet de chauffage de l'élément chauffant n'émanant que de la face avant de l'élément chauffant orientée vers le matériau semi-conducteur et le matériau du creuset étant protégé.

5. Dispositif selon la revendication 4, caractérisé en ce que le dispositif de chauffage peut être éloigné par une porte dans la chambre d'écluse.

6. Dispositif selon la revendication 4, caractérisé par un écran thermique, qui entoure l'élément chauffant lorsqu'il a été abaissé dans la direction du matériau semi-conducteur.
